# DEMANDE DE BREVET EUROPEEN

(11) **EP 0 834 923 A1**
(43) Date de publication de la demande: **08.04.1998**
(21) Numéro de dépôt: 97402337.6
(22) Date de dépôt: 06.10.1997
(51) Int. Cl.: H01L 25/07

(54) **Module de puissance à composants électroniques semi-conducteurs de puissance et interrupteur de forte puissance comportant au moins un tel module de puissance**

(30) Priorité: 07.10.1996 FR 9612188; 30.01.1997 FR 9700996
(71) Demandeur: GEC ALSTHOM TRANSPORT SA, 75116 Paris (FR)
(72) Inventeur: Fellmann, Daniel, 69390 Millery (FR)
(74) Mandataire: Gosse, Michel

(57) **Abrégé**

La présente invention porte sur un module de puissance (1) à composants électroniques semi-conducteurs de puissance (2) disposés sur un substrat (3) associé à une embase (4), caractérisé en ce que ladite embase (4) est en contact direct avec un élément de refroidissement (6).

## Description

La présente invention concerne les dispositifs électroniques de puissance, en général, et porte, plus particulièrement, sur un module de puissance à composants électroniques semi-conducteurs de puissance, ainsi que sur un interrupteur de forte puissance comportant au moins un tel module de puissance.

La présente invention trouve application dans le domaine des fortes puissances, c'est à dire concerne les interrupteurs dont le domaine de marché correspond aux interrupteurs susceptibles de fournir un courant électrique supérieur à 50 A, étant entendu que le domaine de marché des interrupteurs susceptibles de fournir un courant électrique inférieur à 50 A est un domaine distinct.

Les interrupteurs de forte puissance, par exemple à composants électroniques semi-conducteurs de puissance du type IGBT, de l'art antérieur sont en général obtenus au moyen de modules de grande taille ou par assemblage de plusieurs modules de taille moyenne mis en parallèle.

La technique d'encapsulation de ces modules de grande taille et de ces modules de taille moyenne consiste à remplir un boîtier plastique contenant les composants électroniques semi-conducteurs de puissance au moyen d'un gel silicone et de fermer le boîtier soit au moyen d'un couvercle, soit au moyen d'une résine de fermeture, généralement de l'époxy, soit au moyen d'un couvercle et d'une résine de fermeture.

Un inconvénient majeur des modules de grande taille et des modules de taille moyenne pour interrupteurs de puissance de l'art antérieur est leur encombrement trop important.

Aussi un but de l'invention est-il un module de puissance à composants électroniques semi-conducteurs de puissance, ainsi qu'un interrupteur de forte puissance comportant au moins un tel module de puissance, ne présentant pas l'inconvénient majeur des modules et des interrupteurs de l'art antérieur.

Conformément à l'invention, le module de puissance à composants électroniques semi-conducteurs de puissance disposés sur un substrat associé à une embase, se caractérise en ce que ladite embase est en contact direct avec un élément de refroidissement.

Le module de puissance à composants électroniques semi-conducteurs de puissance de l'invention satisfait également à l'une au moins des caractéristiques suivantes:
- ladite embase et ledit élément de refroidissement constituent un ensemble monobloc,
- ladite embase est réalisée au moyen d'un procédé de matriçage d'un matériau bon conducteur thermique,
- ledit matériau bon conducteur thermique est du cuivre,
- ledit module de puissance comporte un nombre de composants électroniques semi-conducteurs de puissance inférieur ou égal à un ratio de l'ordre de 2/3 du nombre de composants électroniques semi-conducteurs de puissance d'un module classique,
- l'interrupteur de forte puissance comportant au moins un tel module de puissance étant susceptible de fournir un courant électrique de l'ordre de N ampères, le nombre de composants électroniques semi-conducteurs de puissance constituant chacun desdits modules de puissance est tel que chacun desdits modules de puissance est susceptible de fournir un courant électrique au plus de l'ordre de 2N/3 ampères dans le cas d'un module classique,
- lesdits composants électroniques semi-conducteurs de puissance et ledit substrat sont encapsulés au moyen d'un procédé de moulage par transfert sous pression de résine dans un moule,
- lesdits composants électroniques semi-conducteurs de puissance et ledit substrat sont encapsulés au moyen d'un procédé de coulage de résine dans un boîtier,
- lesdits composants électroniques semi-conducteurs de puissance et ledit substrat sont encapsulés au moyen d'un procédé de protection localisé par goutte de résine,
- lesdits composants électroniques semi-conducteurs de puissance sont des composants constitués de pastilles de silicium.

Conformément à une autre caractéristique de l'invention, l'interrupteur de forte puissance comporte au moins un module de puissance de l'invention.

Un avantage fondamental du module de puissance à composants électroniques semi-conducteurs de puissance et de L'interrupteur de forte puissance comportant au moins un tel module de puissance de l'invention est de permettre une réduction de la surface de silicium nécessaire et donc du coût.

A titre d'exemple, l'augmentation de l'efficacité du refroidissement des modules de puissance du fait que l'embase est, selon une caractéristique de l'invention, en contact direct avec l'élément de refroidissement, permet un gain de 30% sur le coût.

Un autre avantage du module de puissance à composants électroniques semi-conducteurs de puissance et de l'interrupteur de forte puissance comportant au moins un tel module de puissance de l'invention est une réduction du poids.

Un autre avantage du module de puissance à composants électroniques semi-conducteurs de puissance et de l'interrupteur de forte puissance comportant au moins un tel module de puissance de l'invention est une réduction de la surtension de commutation du fait que l'inductance de la boucle est réduite d'un facteur de l'ordre de deux.

Un autre avantage du module de puissance à composants électroniques semi-conducteurs de puissance est de pouvoir être fabriqué sur des lignes de fabrication industrielles du fait de sa taille réduite.

D'autres buts, caractéristiques et avantages de l'invention apparaîtront à la lecture de la description du mode de réalisation préféré du module de puissance à composants électroniques semi-conducteurs de puissance et de l'interrupteur de forte puissance comportant au moins un tel module de puissance, description faite en liaison avec les dessins dans lesquels:
- les figures 1A et 1B représentent une vue en perspective selon chaque face principale d'un module de puissance à composants électroniques semi-conducteurs de puissance conforme à l'invention,
- la figure 1C est une coupe du module de puissance à composants électroniques semi-conducteurs de puissance conforme à l'invention,
- la figure 2 montre une vue en perspective d'un interrupteur de forte puissance à refroidissement intégré comportant huit modules de puissance de l'invention.

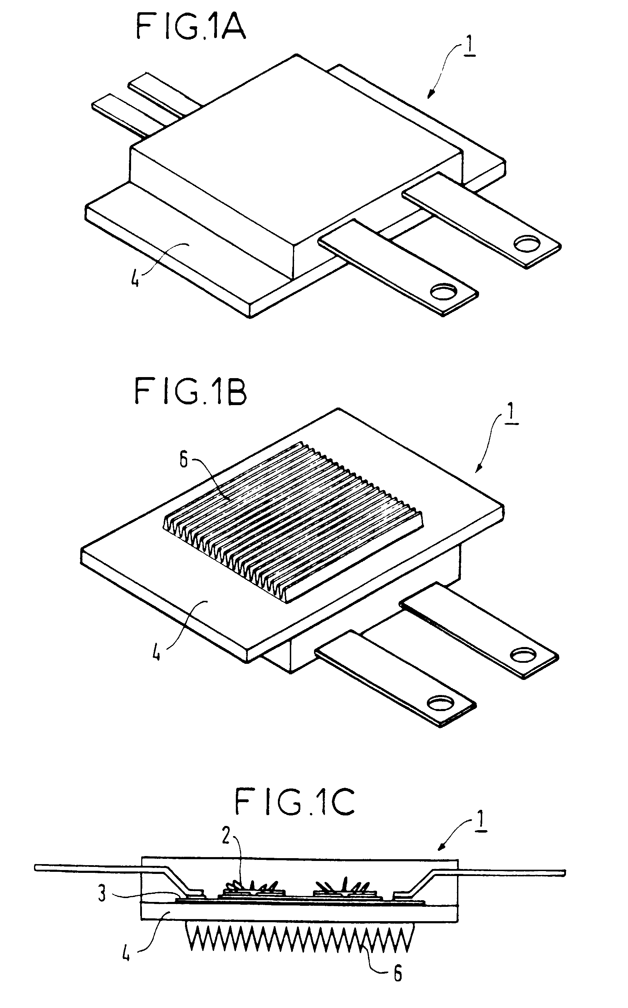

Les figures 1A et 1B représentent une vue en perspective d'un module de puissance à composants électroniques semi-conducteurs de puissance conforme à l'invention.

La figure 1C est une coupe du module de puissance à composants électroniques semi-conducteurs de puissance conforme à l'invention.

De manière générale, les composants électroniques semi-conducteurs de puissance 2 du module de puissance 1 sont disposés sur un substrat 3 associé à une embase 4.

Conformément à une caractéristique essentielle du module de puissance 1 de l'invention, l'embase 4 est en contact direct avec un élément de refroidissement 6, par exemple un radiateur.

Conformément à un mode de réalisation préféré, l'embase 4 et l'élément de refroidissement 6 constituent un ensemble monobloc.

L'embase 4 est réalisée au moyen d'un procédé de matriçage d'un matériau bon conducteur thermique, par exemple le cuivre.

Les modules de puissance comporte un nombre de composants électroniques semi-conducteurs de puissance inférieur ou égal à un ratio de l'ordre de 2/3 du nombre de composants électroniques semi-conducteurs de puissance d'un module classique.

L'interrupteur de forte puissance 7 comportant au moins un tel module de puissance 1 étant susceptible de fournir un courant électrique de l'ordre de N ampères, le nombre de composants électroniques semi-conducteurs de puissance 2 constituant chacun des modules de puissance 1 est tel que chacun des modules de puissance 1 est susceptible de fournir un courant électrique au plus de l'ordre àe 2N/3 ampères dans le cas d'un module classique.

L'embase 4 est de préférence en contact direct avec un élément de refroidissement 6, par exemple un radiateur.

Les composants électroniques semi-conducteurs de puissance 2 et le substrat 3 sont encapsulés au moyen d'un procédé de moulage par transfert sous pression de résine dans un moule.

Les composants électroniques semi-conducteurs de puissance 2 et le substrat 3 peuvent également être encapsulés au moyen d'un procédé de coulage de résine dans un boîtier.

Les composants électroniques semi-conducteurs de puissance et le substrat peuvent encore être encapsulés au moyen d'un procédé de protection localisé par goutte de résine.

Les composants électroniques semi-conducteurs de puissance 2 sont des composants constitués de pastilles de silicium.

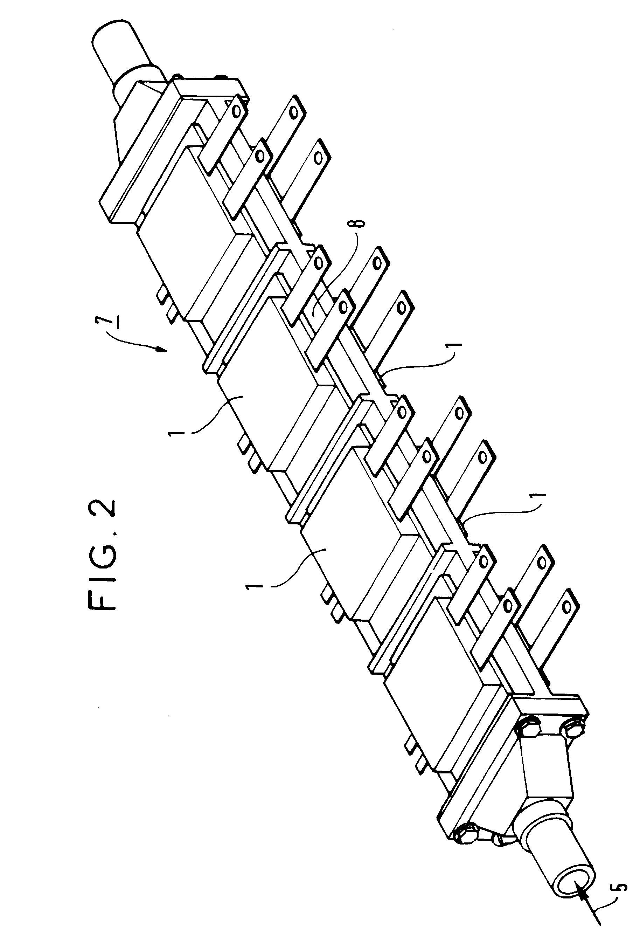

La figure 2 montre une vue en perspective d'un interrupteur de forte puissance 7 comportant huit modules de puissance 1 de l'invention.

Les huit modules de puissance 1 sont disposés par paire se faisant face et sont répartis le long d'un conduit de refroidissement 8.

Les éléments de refroidissement, à savoir: les radiateurs, de chacun des modules de puissance 1 débouchent dans le conduit de refroidissement 8 à l'intérieur duquel circule un liquide de refroidissement 5.

## Revendications

1. Module de puissance (1) à composants électroniques semi-conducteurs de puissance (2) disposés sur un substrat (3) associé à une embase (4), caractérisé en ce que ladite embase (4) est en contact direct avec un élément de refroidissement (6).

2. Module selon la revendications 1, dans lequel ladite embase (4) et ledit élément de refroidissement (6) constituent un ensemble monobloc.

3. Module selon l'une quelconque des revendications 1 ou 2, dans lequel ladite embase (4) est réalisée au moyen d'un procédé de matriçage d'un matériau bon conducteur thermique.

4. Module selon la revendication 3, dans lequel ledit matériau bon conducteur thermique est du cuivre.

5. Module selon l'une quelconque des revendications 1 à 4, dans lequel ledit module de puissance (1) comporte un nombre de composants électroniques semi-conducteurs de puissance (2) inférieur ou égal à un ratio de l'ordre de 2/3 du nombre de composants électroniques semi-conducteurs de puissance d'un module classique.

6. Module selon l'une quelconque des revendications 1 à 4, dans lequel l'interrupteur de forte puissance (7) comportant au moins un tel module de puissance (1) étant susceptible de fournir un courant électrique de l'ordre de N ampères, le nombre de composants électroniques semi-conducteurs de puissance (2) constituant chacun desdits modules de puissance (1) est tel que chacun desdits modules de puissance serait susceptible de fournir un courant électrique au plus de l'ordre de 2N/3 ampères dans le cas d'un module classique.

7. Module selon l'une quelconque des revendications 1 à 6, dans lequel lesdits composants électroniques semi-conducteurs de puissance (2) et ledit substrat (3) sont encapsulés au moyen d'un procédé de moulage par transfert sous pression de résine dans un moule.

8. Module selon l'une quelconque des revendications 1 à 6, dans lequel lesdits composants électroniques semi-conducteurs de puissance (2) et ledit substrat (3) sont encapsulés au moyen d'un procédé de coulage de résine dans un boîtier.

9. Module selon l'une quelconque des revendications 1 à 6, dans lequel lesdits composants électroniques semi-conducteurs de puissance (2) et ledit substrat (3) sont encapsulés au moyen d'un procédé de protection localisé par goutte de résine.

10. Module selon l'une quelconque des revendications 1 à 6, dans lequel lesdits composants électroniques semi-conducteurs de puissance (2) sont des composants constitués de pastilles de silicium.

11. Interrupteur de forte puissance (7) comportant au moins un module de puissance (1) selon l'une quelconque des revendications précédentes.
